# EUROPEAN PATENT APPLICATION

(11) **EP 4 761 525 A1**
(43) Date of publication of application: **17.06.2026**
(21) Application number: 25179736.1
(22) Date of filing: 29.05.2025
(51) Int. Cl.: H10F 71/00, H10F 77/20

(54) **PHOTOVOLTAIC MODULE**

(30) Priority: 12.12.2024 CN 202411838266
(71) Applicant: JINKO SOLAR CO., LTD, Shangrao Jiangxi 334100 (CN); Jinko Solar (Haining) Co., Ltd., Haining City, Zhejiang 314415 (CN)
(72) Inventor: TAO, Wusong, Shangrao Economic Development Zone Jiangxi (CN); WANG, Luchuang, Shangrao Economic Development Zone Jiangxi (CN); PENG, Yingying, Shangrao Economic Development Zone Jiangxi (CN); FANG, Sheng, Shangrao Economic Development Zone Jiangxi (CN)
(74) Representative: Balder IP Law, S.L.

(57) **Abstract**

Provided is a photovoltaic module including a back-contact solar cell, first mark points, second mark points, and an insulating layer. The back-contact solar cell includes first collection regions and second collection regions, and first fingers and second fingers. Two adjacent first fingers in a same row of first fingers along the first direction are spaced apart by a respective second collection region. Two adjacent second fingers in a same row of second fingers along the first direction are spaced apart by a respective first collection region The first mark points includes a first sub-mark point spaced apart from an adjacent second collection region by a first distance. The insulating layer includes a first insulating including a first insulating portion disconnected at the first sub-mark point to form a first portion, the first sub-mark point is spaced apart from the first portion by a second distance, and a ratio of the first distance to the second distance ranges from 2 to 30.

## Description

### TECHNICAL FIELD

Embodiments of the present disclosure relate to the field of photovoltaic technologies, and in particular, to a photovoltaic module.

### BACKGROUND

In the current manufacturing process of a crystalline silicon solar cell, most operations are performed by automated machinery. Therefore, alignment marks (mark points) are required for positioning, and a series of operations such as electrode printing, insulating adhesive printing, and solder paste printing are performed with reference to the alignment mark.

In other words, one of the factors influencing the yield and aesthetic quality of a finished photovoltaic module is a positioning accuracy of the mark point. Thus, mark points must exhibit sharp contours and high color contrast to facilitate capture by a camera, and hence subsequent operations, such as electrode printing, insulating adhesive printing, and solder paste printing, are performed based on the mark point.

### SUMMARY

Embodiments of the present disclosure provide a photovoltaic module, which is at least favorable to improving the yield of the photovoltaic module.

According to some embodiment, the present disclosure provides a photovoltaic module. The photovoltaic module includes a back-contact solar cell, first mark points, second mark points, and an insulating layer. The back-contact solar cell includes first collection regions and second collection regions alternatingly arranged along a first direction, and first fingers and second fingers. The first fingers are disposed in a form of a first array, the first array includes a plurality of rows of first fingers disposed at intervals along a second direction, first fingers in each row of the plurality of rows of first fingers are disposed at intervals along the first direction and extends in the first direction, and two adjacent first fingers in a same row of first fingers along the first direction are spaced apart by a respective second collection region and have two first ends adjacent to the respective second collection region. The second fingers are disposed in a form of a second array, the second array includes a plurality of rows of second fingers disposed at intervals along the second direction, second fingers in each row of the plurality of rows of second fingers are disposed at intervals along the first direction and extends in the first direction, and two adjacent second fingers in a same row of second fingers along the first direction are spaced apart by a respective first collection region and have two second ends adjacent to the respective first collection region. The plurality of rows of first fingers and the plurality of rows of second fingers are alternatingly arranged along the second direction. The first mark points are disposed on the first fingers and configured for positioning of the first fingers, where the first mark points include a first sub-mark point spaced apart from a nearest second collection region by a first distance. The second mark points are configured for positioning of the second fingers, where the second mark points do not overlap with the first mark points. The insulating layer include a first insulating layer covering the first ends of the first fingers. The first insulating layer includes a first insulating portion, wherein the first insulating portion is disposed on a first finger having a respective first sub-mark point disposed thereon, and has disconnected first and second portions, the first portion being on a side of the respective first sub-mark point facing a nearest second collection region and the second portion being on a side of the respective first sub-mark point facing away the nearest second collection region, the respective first sub-mark point is spaced apart from the first portion by a second distance, and a ratio of the first distance to the second distance ranges from 2 to 30.

In some embodiments, the second distance ranges from 0.1 mm to 0.3 mm.

In some embodiments, the first mark points further includes a second sub-mark point closer to the respective first collection region than the first sub-mark point, the insulating layer further includes a second insulating layer covering the second ends of the second fingers, the second insulating layer includes a second insulating portion adjacent to the second sub-mark point, the second insulating portion is disconnected at its location adjacent to second sub-mark point, and a distance between the r second sub-mark point and an end of the second insulating portion ranges from 0.2 mm to 0.5 mm.

In some embodiments, the second insulating portion includes an insulating region and a gap region, where the gap region is opposite to the second sub-mark point, and a length of the gap region along the first direction ranges from 0.4 mm to 1.5 mm.

In some embodiments, a length of the insulating region disposed between the gap region and a respective first collection region ranges from 0.8 mm to 3 mm.

In some embodiments, the first distance ranges from 0.8 mm to 3 mm.

In some embodiments, a distance between the respective first mark point and a closest second mark point is greater than 1.62 mm.

In some embodiments, an opening shape of at least one of the respective second mark point or the respective first mark point is a hollow pattern, the hollow pattern includes a hollow region and a peripheral region, an electrode paste is disposed the peripheral region, a concave-convex structure is disposed in the hollow region, and the respective first finger or the respective second finger is made of an electrode paste.

In some embodiments, the back-contact solar cell further includes a cell substrate, and the hollow region exposes a textured surface of the cell substrate.

In some embodiments, the concave-convex structure includes protrusions or grooves.

In some embodiments, the respective second mark point is disposed on a respective second finger, between a respective second finger and a respective first finger, or in a respective second collection region.

In some embodiments, the back-contact solar cell further includes first welding portions disposed in a respective first collection region, and second welding portions disposed in a respective second collection region.

In some embodiments, the back-contact solar cell further includes a cell substrate, wherein the cell substrate includes a substrate having a first surface and a second surface opposite to each other, and the first surface includes a textured structure.

In some embodiments, the second surface of the substrate includes first regions and second regions alternatingly arranged, each respective first region of the first regions is one of a P-type region and an N-type region, and each respective second region of the second regions is the other of the P-type region and the N-type region, a gap region is defined between the P-type region and the N-type region, the respective first finger is disposed in the respective first region, and the respective second finger is disposed in the respective second region.

In some embodiments, the cell substrate has a first edge, a second edge opposite to the first edge, and two third edges configured to connect the first edge and the second edge respectively, and a chamfer is formed at each of a junction of the first edge and the third edge and a junction of the second edge and the third edge.

In some embodiments, the back-contact solar cell further includes a first edge busbar adjacent to the first edge and a second edge busbar adjacent to the second edge, and no welding portion is disposed on each of the first edge busbar and the second edge busbar.

In some embodiments, the back-contact solar cell further includes: a first busbar disposed in a respective first collection region and connected to the first fingers, and a second busbar disposed in a respective second collection region and connected to the second fingers.

In some embodiments, the first edge busbar has a conductivity type different from a conductivity type of the second busbar.

In some embodiments, a material of the insulating layer is made of an insulating adhesive, including an ethylene-vinyl acetate (EVA) adhesive, an acrylic adhesive, a polyethylene terephthalate (PET) adhesive, or a polyvinyl alcohol (PVA) adhesive.

### BRIEF DESCRIPTION OF THE DRAWINGS

One or more embodiments are exemplarily described with reference to the corresponding figures in the accompanying drawings, and the exemplary descriptions are not to be construed as limiting the embodiments. Unless otherwise particularly stated, the figures in the accompanying drawings are not drawn to scale. To describe the technical solutions in the embodiments of the present disclosure or in the conventional technologies more clearly, the following briefly introduces the accompanying drawings required for describing the embodiments. Apparently, the accompanying drawings in the following description show merely some embodiments of the present disclosure, and a person of ordinary skill in the art can still derive other accompanying drawings from these accompanying drawings without creative efforts.
FIG. 1 is a schematic structure view of a photovoltaic module according to some embodiments of the present disclosure.
FIG. 2 is a partial enlarged view of part A in FIG. 1.
FIG. 3 is a schematic structure view of a first insulating portion in a photovoltaic module according to some embodiments of the present disclosure.
FIG. 4 is a partial enlarged view of part B in FIG. 1.
FIG. 5 is a schematic structure view of a second insulating portion in a photovoltaic module according to some embodiments of the present disclosure.
FIG. 6 is a schematic structure view of a first mark point in a photovoltaic module according to some embodiments of the present disclosure.
FIG. 7 is a cross-sectional view taken along a C1-C2 plane of FIG. 6.
FIG. 8 is another cross-sectional view taken along a C1-C2 plane of FIG. 6.

### DETAILED DESCRIPTION

As known from the background, the yield of the photovoltaic module is poor.

Embodiments of the present disclosure provide a photovoltaic module, where positions of a first mark point and a second mark point, as well as the position and ratio of the first mark point relative to a first insulating portion, are designed so that the first mark point and the second mark point can be easily captured by a camera while ensuring electrical insulation, and then subsequent processes such as dispensing and solder paste printing are performed, thereby improving the yield of the photovoltaic module.

In the description of the embodiments of the present disclosure, the technical terms "first" "second" and the like are only used to distinguish different objects and cannot be understood as indicating or implying relative importance or implicitly indicating the number, specific order, or primary and secondary relationship of the indicated technical features. In the description of the embodiments of the present disclosure, "a plurality of" means at least two, unless otherwise specified.

Reference herein to "embodiment" means that a particular feature, structure, or characteristic described in connection with the embodiment may be included in at least one embodiment of the present disclosure. The appearances of this phrase in various places in the specification are not necessarily all referring to the same embodiment, nor are separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" is merely an association relationship describing associated objects, indicating that there may be three relationships, for example, A and/or B, which may indicate that A exists, A and B exist at the same time, and B exists. In addition, the character "/" in this specification generally indicates an "or" relationship between the associated objects.

In the description of the embodiments of the present disclosure, the term "a plurality of" means at least two, similarly, "a plurality of groups" means at least two groups, and "a plurality of pieces" means at least two pieces.

In the description of the embodiments of the present disclosure, orientation or positional relationship indicated by technical terms "center", "transverse", "longitudinal", "length", "width", "thickness", "up", "down", "front", "rear", "left", "right", "vertical", "horizontal", "top", "bottom", "inside" "outside", "clockwise", "counterclockwise", "axial", "radial", "circumferential" and the like are orientations or positional relationships based on those shown in the accompanying drawings, which are intended only to facilitate the description of embodiments of the present disclosure and to simplify the description, and are not intended to indicate or imply that the device or element referred to must have a particular orientation, be constructed and operated with a particular orientation, and therefore are.

In the description of the embodiments of the present disclosure, unless otherwise specified and limited, technical terms "mounted", "connected", "connecting", "fixed", etc. are to be understood in a broad sense. For example, it may be a fixed connection, a removable connection, or a one-piece connection, it may be a mechanical connection, or an electrical connection, it may be a direct connection, or an indirect connection through an intermediate medium, and it may be a connection between two elements or an interaction between the two elements. For those of ordinary skill in the art, specific meanings of the above terms in the embodiments of the present disclosure may be understood according to specific situations.

In the accompanying drawings corresponding to the embodiments of the present disclosure, for better understanding and ease of description, the thickness and area of a layer are enlarged. When a component (e.g., a layer, a film, a region, or a substrate) is described as being formed over another component or over a surface of another component, the component may be "directly" on the surface of another component, or a third component may exist between the two components. In contrast, when a component is described as being formed on a surface of another component or a surface of a component is formed or provided with another component, there is no third component between the two components. In addition, when a component is described as being "substantially" formed on/over another component, it means that the component is not formed on/over the entire surface (or front surface) of another component, nor on/over a portion of the edge of the entire surface.

In the description of the embodiments of the present disclosure, when a component "includes" another component, unless otherwise stated, other components are not excluded, and other components may be further included in the component. In addition, when a component such as a layer, a film, a region, or a plate is referred to as being "over/disposed over" another component, it may be "directly on" another component (i.e., being on the surface of another component and there is no other component therebetween), or another component may exist therebetween. Furthermore, when a component such as a layer, film, region, plate, etc. is "directly on" another component, or when a component such as a layer, film, region, plate, etc. is disposed on the surface of another component, it means that no other component is disposed therebetween.

The terminology used in the description of the various described embodiments herein is for the purpose of describing particular embodiments only and is not intended to be limiting. As used in the description of the various embodiments described and the appended claims, "the portion" is also intended to include the plural forms as well, unless the context clearly indicates otherwise. The component includes a layer, a film, a region, or a plate, etc.

The following describes the embodiments of the present disclosure in detail with reference to the accompanying drawings. However, a person of ordinary skill in the art may understand that in the embodiments of the present disclosure, many technical details are provided to make readers better understand the embodiments of the present disclosure. However, even without these technical details and various changes and modifications based on the following embodiments, the technical solutions claimed in the embodiments of the present disclosure can be implemented.

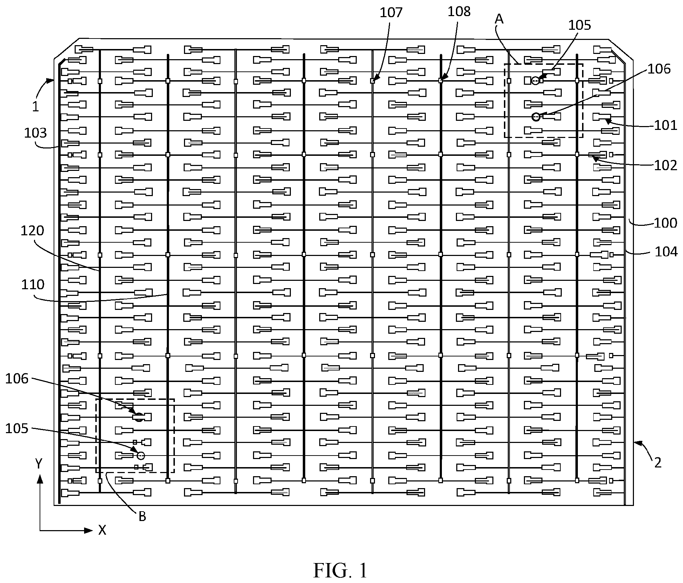

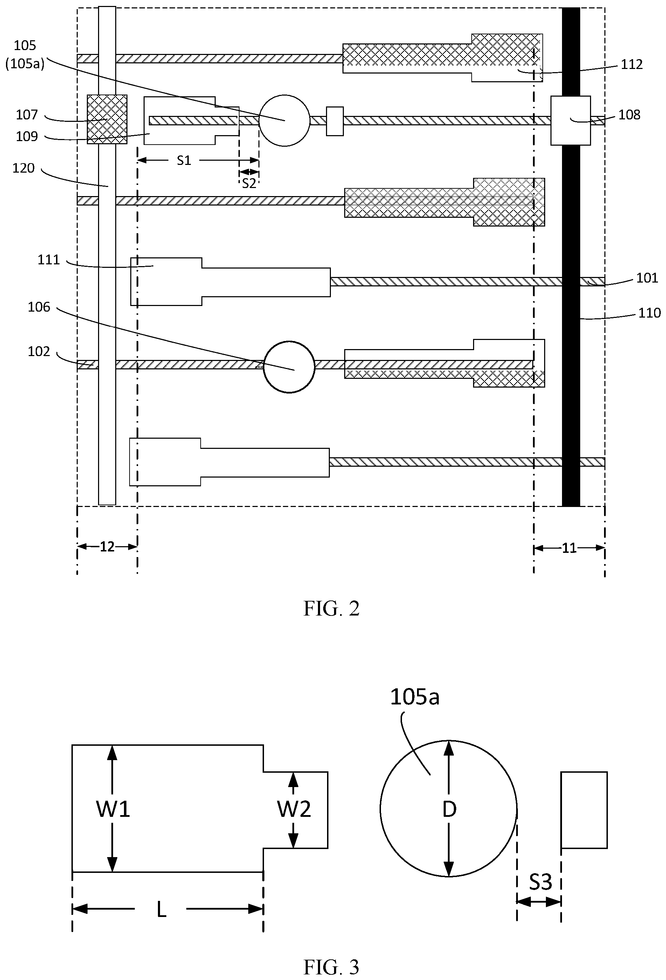

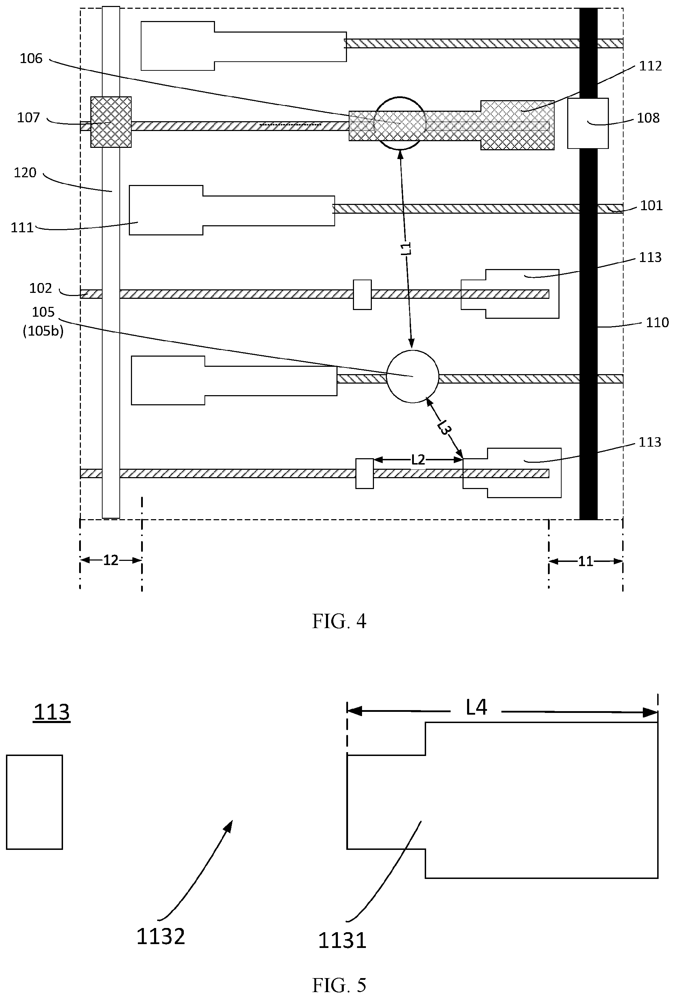

FIG. 1 is a schematic structure view of a photovoltaic module according to some embodiments of the present disclosure, FIG. 2 is a partially enlarged view of part A in FIG. 1, FIG. 3 is a schematic structure view of a first insulating portion in a photovoltaic module according to some embodiments of the present disclosure, FIG. 4 is a partially enlarged view of part B in FIG. 1, and FIG. 5 is a schematic structure view of a second insulating portion in a photovoltaic module according to some embodiments of the present disclosure.

Embodiments of the present disclosure provide a photovoltaic module to improve the yield of the photovoltaic module.

Referring to FIG. 1 to FIG. 5, the photovoltaic module includes: a back-contact solar cell, first mark points 105, second mark points 106, and an insulating layer. The back-contact solar cell includes first collection regions 11 and second collection regions 12 alternatingly arranged along a first direction X, and first fingers 101 and second fingers 102 alternatingly arranged along a second direction Y. Each first finger 101 of the first fingers 101 extends in the first direction X to traverse the first collection regions 11, and is disconnected at the second collection regions 12 to form two respective opposing first ends adjacent to each of the second collection regions 12. Each second finger 102 of the second fingers 102 extends in the first direction X to traverse the second collection regions 12, and is disconnected at the first collection regions 11 to form two respective opposing second ends adjacent to each of the first collection regions 11. The first mark points 105 are disposed on the first fingers 101 and configured to position the first fingers 101. The first mark points 105 includes first sub-mark points 105a, and each respective first sub-mark point 105a is spaced apart from an adjacent second collection region 12 by a first distance S1. The second mark points 106 is configured to position the second fingers 102 and be non-overlapping with the first mark points 105. The insulating layer includes a first insulating layer 111 covering the first ends of the first fingers 101 adjacent to the second collection regions 12. The first insulating layer 111 includes at least one first insulating portion 109 disposed on respective first fingers 101 where the first sub-mark points 105a are disposed. A respective first insulating portion 109 is disconnected at the respective first sub-mark point 105a to form a first portion on a side of the respective first sub-mark point 105a facing the adjacent second collection region 12 and a second portion on a side of the respective first sub-mark point 105a facing away the adjacent second collection region 12. The respective first sub-mark point 105a is spaced apart from the first portion by a second distance S2. A ratio of the first distance S1 to the second distance S2 ranges from 2 to 30. In some embodiment, referring to FIG. 1 to FIG. 5, the photovoltaic module includes a back-contact solar cell, first mark points 105, second mark points 106, and an insulating layer. The back-contact solar cell includes first collection regions 11 and second collection regions 12 alternatingly arranged along a first direction X, and first fingers 101 and second fingers 102. The first fingers 101 are disposed in a form of a first array, the first array includes a plurality of rows of first fingers 101 disposed at intervals along a second direction Y, first fingers 101 in each row of the plurality of rows of first fingers 101 are disposed at intervals along the first direction X and extends in the first direction X, and two adjacent first fingers 101 in a same row of first fingers 101 along the first direction X are spaced apart by a respective second collection region 12 and have two first ends adjacent to the respective second collection region 12. The second fingers 102 are disposed in a form of a second array, the second array includes a plurality of rows of second fingers 102 disposed at intervals along the second direction Y, second fingers 102 in each row of the plurality of rows of second fingers 102 are disposed at intervals along the first direction X and extends in the first direction X, and two adjacent second fingers 102 in a same row of second fingers 102 along the first direction X are spaced apart by a respective first collection region 11 and have two second ends adjacent to the respective first collection region 11. The plurality of rows of first fingers 101 and the plurality of rows of second fingers 102 are alternatingly arranged along the second direction Y. The first mark points 105 are disposed on the first fingers 101 and configured for positioning of the first fingers 101. The first mark points 105 include a first sub-mark point 105a. The first sub-mark point 105a is spaced apart from a nearest second collection region 12 by a first distance S1. The second mark points 106 are configured for positioning of the second fingers 102, and does not overlap with the first mark points 105. The insulating layer includes a first insulating layer 109 covering the first ends of the first fingers 101. The first insulating layer 111 includes a first insulating portion 109. The first insulating portion 109 is disposed on a first finger 101 having a respective first sub-mark point 105a disposed thereon, and has disconnected first and second portions. The first portion is on a side of the respective first sub-mark point 105a facing a nearest second collection region 12, and the second portion is on a side of the respective first sub-mark point 105a facing away the nearest second collection region 12. The respective first sub-mark point 105a is spaced apart from the first portion by a second distance S2, and a ratio of the first distance S1 to the second distance S2 ranges from 2 to 30.

In the photovoltaic module according to the embodiments of the present disclosure, the first mark points 105 and the second mark points 106 are provided. The first mark points 105 are configured to position the first fingers 101, the second mark points 106 are configured to position the second fingers 102. The first insulating portion 109 is disconnected at the respective first mark point 105 (i.e., the respective first sub-mark point 105a) to the first portion and the second portion, and the first mark point 105 is spaced apart from the first portion by the second distance S2. In this way, areas surrounding the mark points are kept free of insulating adhesive, ensuring clear contours of the mark points for reliable camera capture. The respective first mark point 105 is spaced apart from the second collection region 12 by the first distance S1, and the ratio of the first distance S1 to the second distance S2 ranges from 2 to 30, which ensures that the first mark point 105 is spaced apart from the first end of the first finger 101 by a certain distance so that identification failure of the first mark point 105 due to overlapping of the first mark point 105 with an edge of the first finger 10 can be avoided. Furthermore, the first mark point 105 is spaced apart from the second collection region 12 by a certain distance so that a part of the first finger 101 between the first mark point 105 and the second collection region 12 can be covered by the insulating portion. In this way, short-circuits between the first finger 101 and welding strips of different polarities are prevented.

A back-contact solar cell may be an interdigitated back-contact (IBC) solar cell.

The back-contact solar cell includes a cell substrate 100. The cell substrate 100 includes: a substrate having a first surface and a second surface opposite to each other. The first surface has a textured structure that increases internal reflection of incident light so that optical losses are reduced, thereby improving the photovoltaic conversion efficiency. A front surface field (FSF) layer is formed on the first surface, has doping ions of the same conductivity type as doping ions in the substrate. This FSF utilizes the field passivation effect to reduce the surface minority carrier concentration, thereby lowering the surface recombination rate, while also decreasing series resistance and enhancing electron transport efficiency. Additionally, a first passivation layer and a first anti-reflective layer are formed over the first surface, where the first passivation layer is disposed on the FSF layer, and the first anti-reflective layer is disposed on the passivation layer. Notably, the battery substrate 100 does not necessarily require the inclusion of the FSF layer, the first passivation layer, or the first anti-reflective layer.

The second surface of the substrate includes regions I and regions II alternatingly arranged. The region I is one of a P-type region and an N-type region, and the region II is the other of the P-type region and the N-type region. A gap region is defined between the P-type region and the N-type region. The first finger 101 is disposed in the region I, and the second finger 102 is disposed in the region II.

In some embodiments, no gap region is defined between the P-type region and the N-type region. Instead, an insulating film layer is arranged between the P-type region and the N-type region to achieve electrical insulation therebetween, so that the first finger 101 is insulated from the second finger 102.

In some embodiments, the gap region is flush with the P-type region and the N-type region. That is, no etching is performed on the substrate. Instead, insulation between the P-type region and the N-type region is achieved via some isolating film layers, which may include a passivation layer or an intrinsic semiconductor layer.

In some embodiment, the gap region is lower than the P-type region and also lower than the N-type region. A trench is formed in the gap region. The trench extends from the second surface to the first surface, and is configured to implement automatic isolation between regions of different conductivity types. This eliminates the impact on the cell efficiency due to electric leakage in formation of a PN junction between heavily doped P-type and N-type regions on the back surface of the IBC cell.

In some embodiments, a surface of the gap region may be a polished surface, or may be a textured surface.

In some embodiments, a tunneling silicon oxide layer and a doped polysilicon layer may be formed in each of the P-type region and the N-type region. A P-type doped polysilicon layer is formed in the P-type region, and an N-type doped polysilicon layer is formed in the N-type region. In other embodiments, an intrinsic amorphous silicon layer, a doped amorphous silicon layer, and a transparent conductive layer may be formed in each of the P-type region and the N-type region. A P-type doped amorphous silicon layer is formed in the P-type doped amorphous, and an N-type doped amorphous silicon layer is formed in the N-type region.

In some embodiments, a second passivation layer and a second anti-reflection layer are arranged on the P-type region, the N-type region, and the gap region. The first fingers 101 and the second fingers 102 are disposed on the second anti-reflection layer.

In some embodiments, the cell substrate 100 has a first edge 1, a second edge 2 opposite to the first edge 1, and two third edges (not labeled) configured to connect the first edge 1 and the second edge 2. A chamfer is formed at each of a junction of the first edge and the third edge and a junction of the second edge and the third edge. The reason for the chamfering is that, in conventional solar cells, due to refinement limitations of the single crystal silicon process used in substrate preparation, a monocrystalline silicon ingot can only be currently made in a round shape. The prepared silicon ingot is sliced into monocrystalline silicon wafers in the shape the cross-section of the silicon ingot (with the area calculated to maximize a light exposure area within a unit while minimizing waste of silicon rod material and facilitating preparation of the solar cell sheets and modules). Chamfers are often provided at the junctions of the edges of the substrate to reduce external stresses on the silicon wafers and prevent micro-damages to the corners of the wafers.

In some embodiments, the back-contact solar cell further includes: a first edge busbar 103 adjacent to the first edge 1 and a second edge busbar 104 adjacent to the second edge 2. No welding portion is disposed on each of the first edge busbar 103 and the second edge busbar 104. This configuration prevents edge damages to the solar cell due to stresses caused by the welding strips on the edges of the solar cell.

In some embodiments, the back-contact solar cell further includes a first busbar 110 disposed in the respective first collection region 11 and connected to the first fingers 101, and a second busbar 120 disposed in the respective second collection region 12 and connected to the second fingers 102.

In other embodiments, the back-contact solar cell is a solar cell without busbars. The back-contact solar cell includes a first connection line disposed in the respective first collection region and connected to the first fingers, and a second connection line disposed in the respective second collection region and connected to the second finger.

In some embodiments, a conductivity type of the first edge busbar 103 is different from a conductivity type of the adjacent busbar. For example, in FIG. 1, the first edge busbar 103 has a conductivity type different from a conductivity type of the adjacent second busbar 120.

In some embodiments, in a case where a total number of the first edge busbar 103, the second edge busbar 104, the first busbars 110, and the second busbars 120 is an even number, referring to FIG. 1, the second edge busbar 104 corresponding to the second edge 2 of the substrate has the same conductivity type as the second busbar 120.

In some embodiments, in a case where a total number of the first edge busbar, the second edge busbar, the first busbars, and the second busbars is an odd number, the second edge busbar 104 corresponding to the second edge 2 of the substrate has the same conductivity type as the first busbar.

In some embodiments, the first edge busbar is electrically connected to a solder pad (not shown) disposed between the first edge busbar and the second busbar via a connection wire. In other embodiments, the first edge busbar is electrically connected to the first busbar via a connection line, such as, a first through connection line. Similarly, the second edge busbar may be electrically connected to an adjacent second busbar via a second through connection line, so that charge carriers at the edge are collected while the fracture of the edge of the solar cell is prevented.

Referring to FIG. 2, the first collection region 11 corresponds to a region of the first busbar, and the second collection region 12 corresponds to a region of the second busbar. The first finger 101 is disconnected at the second collection region 12 and the second finger 102 is disconnected at the first collection region 11, so that each of the first finger 101 and the second finger 102 can be divided into small disconnected sections. This helps to avoid short-circuits between fingers and the busbars having different conductive types, for example, between the first finger 101 and the second busbar, and between the second finger 102 and the first busbar.

In some embodiments, the first mark point 105 and the second mark point 106 are configured to position the first finger 101 and the second finger 102 respectively. Based on the position of the first finger 101, the first busbar is arranged, an insulating adhesive is printed on the first finger 101, solder pads are printed on the first busbar, and subsequent welding strip connection processes are carried out. Similarly, based on the position of the second finger 102, the second busbar is arranged, an insulating adhesive is printed on the second finger 102, solder pads are printed on the second busbar, and subsequent welding strip connection processes are carried out.

In some embodiments, a material of the insulating layer may be an insulating adhesive, such as an ethylene-vinyl acetate (EVA) adhesive, an acrylic adhesive, a polyethylene terephthalate (PET) adhesive, or a polyvinyl alcohol (PVA) adhesive.

The insulating layer includes a first insulating layer 111 disposed on the first fingers, and a second insulating layer 112 disposed on the second fingers. The first insulating layer 11 includes the first insulating portions 109, and the second insulating layer 112 includes second insulating portions 113 (with reference to FIG. 4).

In some embodiments, with reference to FIG. 2 or FIG. 4, the first mark point 105 (or the first sub-mark point 105a) is space apart from the second collection region 12 by the first distance S1 ranging from 0.8 mm to 3 mm. Such range makes the first insulating portion 109 on the first finger 101 have a greater length, so that better insulation can be achieved for the first finger 101 to avoid a short-circuit between the first finger 101 and the welding strip connected to the second busbar.

The first distance S1 ranges from 0.8 mm to 1.0 mm, from 1.0 mm to 1.5 mm, from 1.5 mm to 2.0 mm, from 2.0 mm to 2.5 mm, or from 2.5 mm to 3 mm. Specifically, the first distance S1 may be 0.8 mm, 1.2 mm, 1.7 mm, 2.1 mm, 2.4 mm, 2.7 mm, 2.9 mm, or 3 mm.

In some embodiments, the second distance S2 may range from 0.1 mm to 0.3 mm. The range of the second distance S2 can make the distance between the first insulating portion 109 and the first mark point 105 large enough to ensure that the edge of the first mark point 105 is unobstructed. In this way, the first mark point 105 can be directly identified and observed, and serve as a reference for carrying out a series of operations.

The second distance S2 may be 0.1 mm, 0.13 mm, 0.18 mm, 0.2 mm, 0.22 mm, 0.25 mm, 0.27 mm, 0.29 mm, 0.3 mm.

The ratio of the first distance S1 to the second distance S2 ranges from 2 to 30. This ensures that the first mark point 105 is spaced apart from the first end of the first finger 101 by a certain distance so that identification failure of the first mark point 105 due to overlapping of the first mark point 105 with an edge of the first finger 10 can be avoided. Furthermore, the first mark point 105 is spaced apart from the second collection region 12 by a certain distance so that a part of the first finger 101 between the first mark point 105 and the second collection region 12 can be covered by the insulating portion. In this way, short-circuits between the first finger 101 and welding strips of different polarities are prevented.

The ratio of the first distance S1 to the second distance S2 may range from 2 to 5, from 5 to 10, from 10 to 15, from 15 to 20, from 20 to 25, or from 25 to 30. Specifically, the ratio of the first distance S1 to the second distance S2 may be 3, 7, 9, 12, 15, 17, 21, 23, 26, 28, 29, or 30.

In some embodiments, a pattern of the first mark point 105 may be circular (as shown in FIG. 3), annular, square, triangular, or any other shape.

In some embodiments, with reference to FIG. 2 and FIG. 4, the first mark point 105 adjacent to the second collection region 12 is designated as a first sub-mark point 105a, and the first mark point 105 adjacent to the first collection region 11 is designated as a second sub-mark point 105b. A distance between the first sub-mark point 105a and the first portion of the first insulating portion 109 is the second distance S2.

Referring to FIG. 3, a diameter of the first sub-mark point 105a ranges from 0.1 mm to 0.4 mm. Specifically, the diameter of the first sub-mark point 105a may be 0.1 mm, 0.13 mm, 0.18 mm, 0.2 mm, 0.25 mm, 0.28 mm, 0.33 mm, 0.36 mm, or 0.4 mm

The first sub-mark point 105a is spaced apart from the second portion of the first insulating portion 109 by the third distance S3. The third distance S3 may be the same as the second distance S2, which is not described herein any further.

The first portion of the first insulating portion 109 adjacent to the second collection region 12 has two parts, i.e., a first part adjacent to the first collector region 11 and a second part 9 adjacent to the first mark point 105. A width W1 of the first part along the second direction Y is greater than a width W2 of the second part along the second direction Y. The width W1 of the first part ranges from 0.35 mm to 0.55 mm, the width W2 of the second part ranges from 0.15 to 0.35, and a length L of the first part ranges from 0.2 mm to 1.2 mm.

With reference to FIG. 4, the insulating layer includes the second insulating layer 112 covering the second ends of the second fingers 102 adjacent to the second collection regions 12. The second insulating layer 112 includes second insulating portions 113 on the second fingers 102 adjacent to the second sub-mark points 105b. Each second insulating portion 113 is disconnected at its location adjacent to an adjacent second sub-mark point 105b, and a distance L3 is defined between the second sub-mark point 105b and an end of the second insulating portion 113. The distance L3 ranges from 0.2 mm to 0.5 mm.

The distance L3 may range from 0.2 mm to 0.3 mm, from 0.3 mm to 0.4 mm, or from 0.4 mm to 0.5 mm. Specifically, the distance L3 may be 0.2 mm, 0.23 mm, 0.27 mm, 0.31 mm, 0.34 mm, 0.37 mm, 0.45, or 0.5 mm.

In some embodiments, referring to FIG. 4 and FIG. 5, the second insulating portion 113 includes an insulating region 1131 and a gap region 1132. The gap region 1132 is opposite to the second sub-mark point 105b, and a distance L2 of the gap region 1132 along the first direction X ranges from 0.4 mm to 1.5 mm.

Specifically, the distance L2 of the gap region 1132 along the first direction X may range from 0.4 mm to 0.7 mm, from 0.7 mm to 1.2 mm, or from 1.2 mm to 1.5 mm. Specifically, the distance L2 of the gap region 1132 along the first direction X may be 0.4 mm, 0.5 mm, 0.6 mm, 0.7 mm, 0.8 mm, 0.9 mm, 1.0 mm, 1.1 mm, 1.2 mm, 1.3 mm, 1.4 mm, or 1.5 mm.

In some embodiments, a length L4 of the insulating region 1131 disposed between the gap region 1132 and the adjacent first collection region 11 ranges from 0.8 mm to 3 mm.

Specifically, the length L4 of the insulating region 1131 disposed between the gap region 1132 and the first collection region 11 may range from 0.8 mm to 1.2 mm, from 1.2 mm to 1.5 mm, from 1.5 mm to 2.2 mm, or from 2.2 mm to 3 mm. Specifically, the length L4 of the insulating region 1131 disposed between the gap region 1132 and the first collection region 11 may be 0.8 mm, 1.1 mm, 1.3 mm, 1.6 mm, 1.9 mm, 2.1 mm, 2.3 mm, 2.5 mm, 2.6 mm, 2.7 mm, 2.9 mm, or 3 mm.

In some embodiments, a distance L1 between the first mark point 105 and a closest second mark point 106 is greater than 1.62 mm. As such, from a capture angle of the camera, the distance between the first mark point 105 and the second mark point 106 is sufficiently large such that the camera is prevented from simultaneously capturing both the first mark point 105 and the second mark point 106. In this way, misjudgment is avoided, and thus the final yield of the photovoltaic module is not affected.

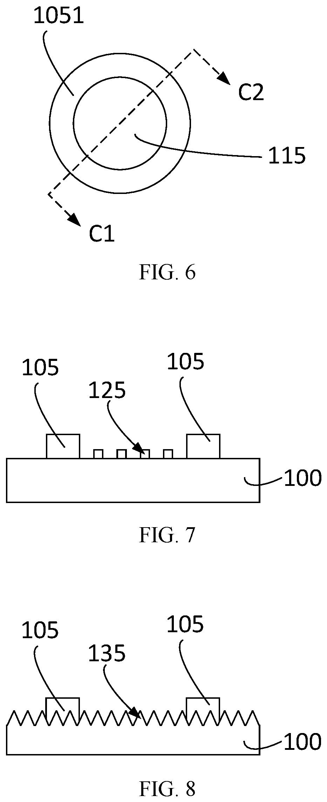

FIG. 6 is a schematic structure view of a first mark point in a photovoltaic module according to some embodiments of the present disclosure, FIG. 7 is a cross-sectional view along a C1-C2 plane of FIG. 6, and FIG. 8 is a cross-sectional view along a C1-C2 plane of FIG. 6.

In some embodiments, an opening shape of at least one of the second mark point and the first mark point is a hollow pattern, the hollow pattern includes a hollow region and a peripheral region, an electrode paste is disposed in the peripheral region to form the at least one of the second mark point and the first mark point, and a concave-convex structure is disposed in the hollow region. The first finger or the second finger is made of the electrode paste. The concave-convex structure in the hollow region may increase the distinction between the first mark point/second mark point and the hollow region. During camera identification, the different refractive indices of light based on the morphological differences may result in varying brightness and darkness. In this case, the camera can quickly identify the first or second mark point based on this brightness contrast, so that the manufacturing difficulty is reduced.

Using a case where the opening shape of the first identification point 105 illustrated in FIG. 6 and FIG. 7 is a hollow pattern as an example, the hollow pattern includes a hollow region 115 and a peripheral region 1051. An electrode paste is disposed in the peripheral region 1051 to form the first mark point 105, and a concave-convex structure 125 is included in the hollow region. The first finger 101 or the second finger 102 is made of the electrode paste.

In some embodiments, referring to FIG. 7, the concave-convex structure 125 may include protrusions or grooves, so that surface roughness of the hollow region is great, leading to different light reflection properties.

In some embodiments, referring to FIG. 8, the concave-convex structure may be a textured surface 135 of the cell substrate, and the hollow region exposes the textured surface of the cell substrate.

In some embodiments, the second mark point 106 is disposed on the second finger 102, between the first finger 101 and the second finger 102, or in the second collection region 12.

In some embodiments, the back-contact solar cell includes first welding portions 108 disposed in a respective first collection region 11, and second welding portions 107 disposed in a respective second collection region 12.

The photovoltaic module also includes: at least one solar cell string, each formed by connecting a plurality of back-contact solar cells as described in any of the above embodiments; an encapsulation adhesive film, covering the at least one solar cell string; and a cover plate, disposed on a side of the encapsulation adhesive film away from the at least one solar cell string.

In some embodiments, a plurality of solar cell strings or solar cells may be electrically connected to each other via welding strips, and the welding strips are welded to the welding portions on the cell cells. For example, one end of a welding strip is electrically connected to welding portions of the first busbar of a first solar cell, and the other end of the welding strip is electrically connected to welding portions of the second busbar of an adjacent second solar cell.

In some embodiments, the insulating layer covers a part of the surface of the solar cell, that is, the insulating layer covers the second ends of the second fingers adjacent to the first collection region to provide electrical insulation between the welding strip corresponding to the first collection region and the second fingers, and similarly, the insulating layer further covers the first ends of the first fingers adjacent to the second collection region to provide electrical insulation between the welding strip corresponding to the second collection region and the first fingers.

In some embodiments, the encapsulation adhesive film may include a first encapsulation adhesive film covering one of a front surface or a back surface of the solar cell, and a second encapsulation adhesive film covering the other of the front surface or the back surface of the solar cell. Specifically, at least one of the first encapsulation adhesive film or the second encapsulation adhesive film may be an organic encapsulation adhesive film such as a polyvinyl butyral (PVB) adhesive film, an EVA adhesive film, a polyethylene octene co-elastomer (POE) adhesive film, or a PET adhesive film.

It should be noted that there is a boundary between the first encapsulation adhesive film and the second encapsulation adhesive film before lamination, and that forming the photovoltaic module after the lamination may eliminate the concepts of the first encapsulation adhesive film and the second encapsulation adhesive film, that is, the first encapsulation adhesive film and the second encapsulation adhesive film already form an integral encapsulation adhesive film.

In some embodiments, the cover plate may be a glass cover plate, a plastic cover plate, or the like that has a light transmission function. Specifically, a surface, facing the encapsulation adhesive film, of the cover plate may be a concave-convex surface, so that the utilization rate of incident light is improved. The cover plate includes a first cover plate and a second cover plate. The first cover plate is opposite to the first encapsulation adhesive film, and the second cover plate is opposite to the second encapsulation adhesive film; or the first cover plate is opposite to one side of the solar cell, and the second cover plate is opposite to the other side of the solar cell.

Persons of ordinary skill in the art shall understand that the above embodiments are merely specific and exemplary embodiments for practicing the present disclosure, and in practice, various modifications may be made to these embodiments in terms of formality and detail, without departing from the spirit and scope of the present disclosure. Variations and modifications may be made by one skilled in the art without departing from the spirit and scope of the present disclosure. Accordingly, the protection scope of the present disclosure is subject to the appended claims.

## Claims

1. A photovoltaic module, comprising:
a back-contact solar cell, including first collection regions (11) and second collection regions (12) alternatingly arranged along a first direction (X), and first fingers (101) and second fingers (102), wherein the first fingers (101) are disposed in a form of a first array, the first array includes a plurality of rows of first fingers (101) disposed at intervals along a second direction (Y), first fingers (101) in each row of the plurality of rows of first fingers (101) are disposed at intervals along the first direction (X) and extends in the first direction (X), and two adjacent first fingers (101) in a same row of first fingers (101) along the first direction (X) are spaced apart by a respective second collection region (12) and have two first ends adjacent to the respective second collection region (12);
wherein the second fingers (102) are disposed in a form of a second array, the second array includes a plurality of rows of second fingers (102) disposed at intervals along the second direction (Y), second fingers (102) in each row of the plurality of rows of second fingers (102) are disposed at intervals along the first direction (X) and extends in the first direction (X), and two adjacent second fingers (102) in a same row of second fingers (102) along the first direction (X) are spaced apart by a respective first collection region (11) and have two second ends adjacent to the respective first collection region (11);
wherein the plurality of rows of first fingers (101) and the plurality of rows of second fingers (102) are alternatingly arranged along the second direction (Y);
first mark points (105), disposed on the first fingers (101) and configured for positioning of the first fingers (101), wherein the first mark points (105) include a first sub-mark point (105a) spaced apart from a nearest second collection region (12) by a first distance (S1);
second mark points (106), configured for positioning of the second fingers (102), wherein the second mark points (106) do not overlap with the first mark points (105); and
an insulating layer, including a first insulating layer (111) covering the first ends of the first fingers (101);
wherein the first insulating layer (111) includes a first insulating portion (109), wherein the first insulating portion (109) is disposed on a first finger (101) having a respective first sub-mark point (105a) disposed thereon, and has disconnected first and second portions, the first portion being on a side of the respective first sub-mark point (105a) facing a nearest second collection region (12) and the second portion being on a side of the respective first sub-mark point (105a) facing away the nearest second collection region (12), the respective first sub-mark point (105a) is spaced apart from the first portion by a second distance (S2), and a ratio of the first distance (S1) to the second distance (S2) ranges from 2 to 30.

2. The photovoltaic module according to claim 1, wherein the second distance (S2) ranges from 0.1 mm to 0.3 mm.

3. The photovoltaic module according to claim 1 or claim 2, wherein the first mark points (105) further includes a second sub-mark point (105b) closer to the respective first collection region (11) than the first sub-mark point (105a), the insulating layer further includes a second insulating layer (112) covering the second ends of the second fingers (102), the second insulating layer (112) includes a second insulating portion (113) adjacent to the second sub-mark point (105b), the second insulating portion (113) is disconnected at its location adjacent to the second sub-mark point (105b), and a distance (L3) between the second sub-mark point (105b) and an end of the second insulating portion (113) ranges from 0.2 mm to 0.5 mm.

4. The photovoltaic module according to claim 3, wherein the second insulating portion (113) includes an insulating region (1131) and a gap region (1132), wherein the gap region (1132) is opposite to the second sub-mark point (105b), and a length (L2) of the gap region (1132) along the first direction (X) ranges from 0.4 mm to 1.5 mm; optionally, a length (L4) of the insulating region (1131) disposed between the gap region (1132) and the respective first collection region (11) ranges from 0.8 mm to 3 mm.

5. The photovoltaic module according to any one of claims 1 to 4, wherein the first distance (S1) ranges from 0.8 mm to 3 mm.

6. The photovoltaic module according to any one of claims 1 to 5, wherein a distance (L1) between a respective first mark point (105) and a closest second mark point (106) is greater than 1.62 mm.

7. The photovoltaic module according to any one of claims 1 to 6, wherein an opening shape of at least one of a respective second mark point (106) or a respective first mark point (105) is a hollow pattern, the hollow pattern includes a hollow region (115) and a peripheral region (1051), an electrode paste is disposed the peripheral region (1051), a concave-convex structure (125) is disposed in the hollow region (115), and a respective first finger (101) or a respective second finger (102) is made of an electrode paste.

8. The photovoltaic module according to claim 7, wherein the back-contact solar cell further includes a cell substrate (100), and the hollow region (115) exposes a textured surface of the cell substrate (100); optionally, the concave-convex structure (125) includes protrusions or grooves.

9. The photovoltaic module according to any one of claims 1 to 8, wherein a respective second mark point (106) is disposed on a respective second finger (102), between a respective second finger (102) and a respective first finger (101), or in a respective second collection region (12).

10. The photovoltaic module according to any one of claims 1 to 9, wherein the back-contact solar cell further includes a first welding portion (108) disposed in a respective first collection region (11), and a second welding portion (107) disposed in a respective second collection region (12).

11. The photovoltaic module according to any one of claims 1 to 10, wherein the back-contact solar cell further includes a cell substrate (100), wherein the cell substrate (100) includes a substrate having a first surface and a second surface opposite to each other, and the first surface includes a textured structure.

12. The photovoltaic module according to claim 11 wherein the second surface of the substrate includes first regions and second regions alternatingly arranged, each respective first region of the first regions is one of a P-type region and an N-type region, and each respective second region of the second regions is the other of the P-type region and the N-type region, a gap region (1132) is defined between the P-type region and the N-type region, a respective first finger (101) is disposed in the respective first region, and a respective second finger (102) is disposed in the respective second region.

13. The photovoltaic module according to any one of claims 1 to 12, wherein the cell substrate (100) has a first edge (1), a second edge (2) opposite to the first edge (1), and two third edges configured to connect the first edge (1) and the second edge (2) respectively, and a chamfer is formed at each of a junction of the first edge (1) and the third edge and a junction of the second edge (2) and the third edge; optionally, the back-contact solar cell further includes a first edge busbar (103) adjacent to the first edge (1) and a second edge busbar (104) adjacent to the second edge (2), and no welding portion is disposed on each of the first edge busbar (103) and the second edge busbar (104).

14. The photovoltaic module according to claim 13, wherein the back-contact solar cell further includes: a first busbar (110) disposed in a respective first collection region (11) and connected to the first fingers (101), and a second busbar (120) disposed in a respective second collection region (12) and connected to the second fingers (12); optionally, the first edge busbar (103) has a conductivity type different from a conductivity type of the second busbar (120).

15. The photovoltaic module according to any one of claims 1 to 14, wherein a material of the insulating layer is made of an insulating adhesive, including an ethylene-vinyl acetate, EVA, adhesive, an acrylic adhesive, a polyethylene terephthalate, PET, adhesive, or a polyvinyl alcohol, PVA, adhesive
